# EUROPEAN PATENT SPECIFICATION

(11) **EP 0 699 343 B1**
(45) Date of publication and mention of the grant of the patent: **12.09.2001**
(21) Application number: 95912921.4
(22) Date of filing: 16.03.1995
(51) Int. Cl.: H01L 21/3205

(54) **THIN FILM CAPACITORS ON GALLIUM ARSENIDE SUBSTRATE AND PROCESS FOR MAKING THE SAME**
DÜNNSCHICHTKONDENSATOREN ÜBER EINEM GALLIUMARSENIDSUBSTRAT UND HERSTELLUNGSVERFAHREN
CONDENSATEURS A COUCHES MINCES SUR UN SUBSTRAT D'ARSENIURE DE GALLIUM ET PROCEDE DE FABRICATION

(30) Priority: 17.03.1994 US 214401; 26.07.1994 US 280601
(43) Date of publication of application: 06.03.1996
(73) Proprietor: SYMETRIX CORPORATION, Colorado Springs, CO 80918 (US); MATSUSHITA ELECTRIC INDUSTRIAL CO., LTD., Kadoma-shi, Osaka (JP)
(72) Inventor: AZUMA, Masamichi, Colorado Springs, CO 80918 (US); PAZ DE ARAUJO, Carlos, A., Colorado Springs, CO 80919 (US); SCOTT, Michael, C., Colorado Springs, CO 80918 (US); UEDA, Toshiyuki, Nara-City, Nara 630 (JP)
(74) Representative: Goodanew, Martin Eric
(86) International application number: US9503254
(87) International publication number: WO9525340

(56) References cited:
- WO-A-93/12542
- JEE (JOURNAL OF ELECTRONIC ENGINEERING), JUNE 1993, JAPAN, vol. 30, no. 318, ISSN 0385-4507, pages 101-104, NOMA A 'Evolution of GaAs ICs containing ferroelectric capacitor'
- DEFECT PROPERTIES AND PROCESSING OF HIGH-TECHNOLOGY NONMETALLIC MATERIALS SYMPOSIUM, BOSTON, MA, USA, 2-4 DEC. 1985, ISBN 0-931837-25-1, 1986, PITTSBURGH, PA, USA, MATER. RES. SOC, USA, pages 35-42, VEST G M ET AL 'Synthesis of metallo-organic compounds for MOD powders and films' cited in the application
- THIRD INTERNATIONAL SYMPOSIUM ON INTEGRATED FERROELECTRICS, COLORADO SPRINGS, CO, USA, 3-5 APRIL 1991, ISSN 1058-4587, INTEGRATED FERROELECTRICS, 1992, UK, pages 231-241, SANCHEZ L E ET AL 'Process technology developments for GaAs ferroelectric nonvolatile memory' cited in the application

## Description

### 1. Field of the Invention

The invention in general relates to the fabrication of integrated circuits utilizing barium strontium titanate, and more particularly to the fabrication of thin film capacitors on gallium arsenide substrates.

### 2. Statement of the Problem

Metal oxide materials, such as barium strontium titanate, commonly referred to as BST, are known to be useful in making integrated circuit thin film capacitors having high dielectric constants. See for example, Kuniaki Koyama, et al., "A Stacked Capacitor With (BaₓSr₁₋ₓ)TiO₃ For 256M DRAM" in *IEDM* (International Electron Devices Meeting) *Technical Digest,* December 1991, pp. 32.1.1- 32.1.4, and United States Patent No. 5,122,923 issued to Shogo Matsubara et al. In both of these references, the BST capacitors are fabricated on a silicon substrate. While the results were good at low frequencies, i.e., about 10 megahertz, up to now, metal oxide thin film capacitors having high capacitance at high frequencies, i.e., at frequencies of 1 gigahertz and higher, have not been possible.

It has been shown that a PZT ferroelectric RAM can be fabricated on gallium arsenide substrate, and further that silicon nitride (SiN) is effective in encapsulating the GaAs to prevent contamination of the PZT. See "Process Technology Developments For GaAs Ferroelectric Nonvolatile Memory" by L.E. Sanchez et al., and "Integrated Ferroelectrics" by J.F. Scott et al., in *Condensed Matter News,* Vol. 1, No.3, 1992. This article also discloses the use of a silicon dioxide (SiO₂) layer between the silicon nitride and the PZT capacitor. However, while the article indicates that a successful memory was made using the process, it also suggests that, due to problems relating to the interaction of the ferroelectric material with the GaAs, one can expect the electronic properties to be at best the same, but, more likely, less than those of a comparable device built on a silicon substrate.

It is well-known, the process of spin coating has been used for making certain types of insulators in integrated circuits, such as spin-on glass (SOG). A carboxylate-based spin-on process has also been used for making metal oxides such as barium titanate, strontium titanate, and barium strontium titanate. See G.M. Vest and S.Singaram, "Synthesis of Metallo-organic Compounds For MOD Powders and Films", *Materials Research Society Symposium Proceedings,* Vol. 60, 1986, pp. 35-42 Robert W. Vest and Jiejie Xu, "PbTiO₃ Thin Films From Metalloorganic Precursors", IEEE Transactions on Ultrasonics, Ferroelectrics, and Frequency Control, Vol 35, No.6, November 1988, pp 711-717, and "Metalorganic Deposition (MOD): A Nonvacuum, Spin-on, Liquid-Based, Thin Film Method", Materials Research Society Bulletin, October 1989, pp. 48-53. However, the quality of the thin films made in these references was far too poor for use in integrated circuits, and these processes have, up to the time of the present invention, been used only for screen printing of metal oxide inks in making relatively macroscopic parts of circuits. Thus this spin-on technique did not appear to be a suitable candidate for a fabrication process which might produce state-of-the-art integrated circuit devices, such as high-capacitance, high-frequency thin film capacitors. Since the use of the GaAs substrate technology and the carboxylate spin-on technology both lead to less satisfactory results than, say, the silicon-based technology and deposition by sputtering, it would seem unlikely that their combination could lead to metal oxide thin film capacitors having high capacitance at high frequencies, i.e. at frequencies of 1 gigahertz and higher.

The invention solves the problem of providing high-capacitance, high-frequency thin film capacitors by a method comprising providing a gallium arsenide substrate; forming a barrier layer on said gallium arsenide substrate; forming a stress reduction layer on said barrier layer; forming a first electrode on said stress reduction layer; forming a dielectric material on a said first electrode; and forming a second electrode on said dielectric material, wherein said step of forming a dielectric material on said first electrode comprises: providing a liquid precursor solution including barium, strontium, and titanium metals; applying said liquid precursor to said first electrode; drying said liquid precursor on said first electrode at a temperature ranging from 200°C to 500°C to yield a dried precursor; and annealing said dried precursor on said first electrode at a temperature ranging from 600°C to 850°C to form barium strontium titanate as said dielectric material.

The use of a barrier layer on the gallium arsenide prevents the volatilization of the GaAs in subsequent annealing steps at high temperature, and the use of a stress-reducing layer on the barrier layer lowers the stress between the gallium arsenide and the BST metal oxide capacitor. Preferably the barrier layer is comprised of silicon nitride (Si₃N₄) and the stress-reduction layer is comprised of silicon dioxide. Preferably the liquid precursor comprises a metal alkoxycarboxylate, and a relatively low temperature spin-on process as described in copending and co-owned United States patent application Serial No. 08/165,082 is preferably used to deposit the BST precursor.

The use of a liquid precursor spin-on process to deposit the BST permits much more accurate control of the stoichiometry of the BST and also results in a much more homogeneous material. This homogeneity and careful control of the drying and annealing processes leads to electronic properties that are much better than for thin film devices fabricated by prior art methods. Further, the homogeneity of the BST significantly reduces the stresses and cracking that accompanied prior art fabrication methods. Numerous other features, objects and advantages of the invention will become apparent from the following description when read in conjunction with the accompanying drawings.
Fig. 1 is a cross-sectional view of an integrated circuit capacitor according to the invention;
Figure 2 is a graph of capacitance in farads (F) versus frequency in gigahertz (GHz) for BST capacitors fabricated according to the process of the invention and annealed at three different temperatures; and
Figure 3 is a flow chart of an exemplary process according to the invention for fabricating a thin-film capacitor.

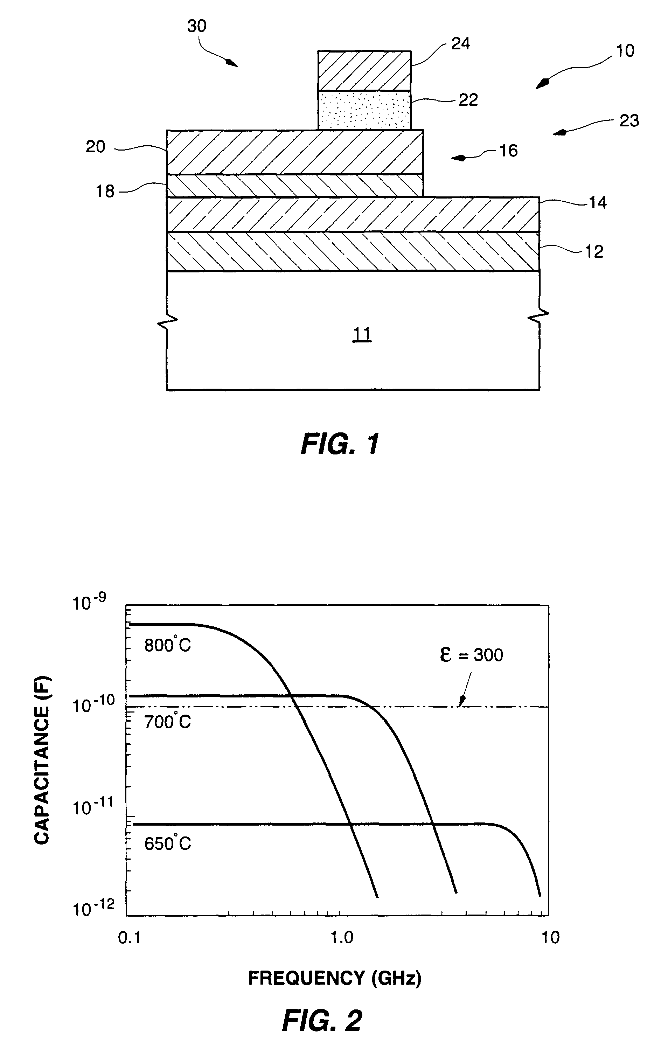

Turning to Figure 1, a thin film capacitor 10 as fabricated in the examples discussed below is shown. The capacitor 10 is formed on a single crystal gallium arsenide (GaAs) wafer 11 encapsulated by a barrier layer 12, preferably of silicon nitride (Si₃N₄) ans a stress reduction layer (14) preferably of silicon dioxide. The capacitor 10 includes a first electrode 16 formed of an adhesion layer 18, preferably of titanium of about 200Å thickness, and a layer 20, preferably of platinum of about 2000Å thickness. Capacitor 10 also includes a layer 22 of a metal oxide, namely BST, then a second electrode layer 24, also preferably about 2000Å thick and made of platinum.

In the integrated circuit art, the GaAs crystal 11 is often referred to as a "substrate". Herein, "substrate" may be used to refer to the GaAs layer 22, but more generally will refer to any support for another layer. For example, the substrate 23 for the metal oxide layer 22 is, immediately, the platinum first electrode layer 20, but also can be interpreted broadly to include the layers 18,14,12 and 11 as well.

The metal oxide is barium strontium titanate (BST) and preferably has the formula Ba_{0.7}Sr_{0.3}TiO₃. The BST may be doped as described in copending United States patent application Serial No. 08/273,592.

Many other materials may be used for any of the layers discussed above, such as layer 18 may comprise tantalum, nickel, tantalum silicide, titanium silicide, nickel silicide, palladium and other materials as well as titanium and layer 20 may be other materials as well as platinum. The electrode 16 may also be formed of more than two layers and the electrode 24 may be formed of more than one layer. Further, it should be understood that Fig. 1 is not meant to be an actual cross-sectional view of any particular portion of an actual electronic device, but is merely an idealized representation which is employed to more clearly and fully depict the structure and process of the invention than would otherwise be possible. For example, the relative thicknesses of the individual layers are not shown proportionately, since otherwise, some layers, such as the substrate 11 would be so thick as to make the drawing unwieldy. It should also be understood that the capacitor 10 preferably forms a portion of an integrated circuit 30 which includes other electronic devices, such as transistors, other capacitors etc., which other devices are not shown for clarity. In addition, the metal oxide layer 22 may be incorporated into other devices, such as ferroelectric FETs, as well as capacitors.

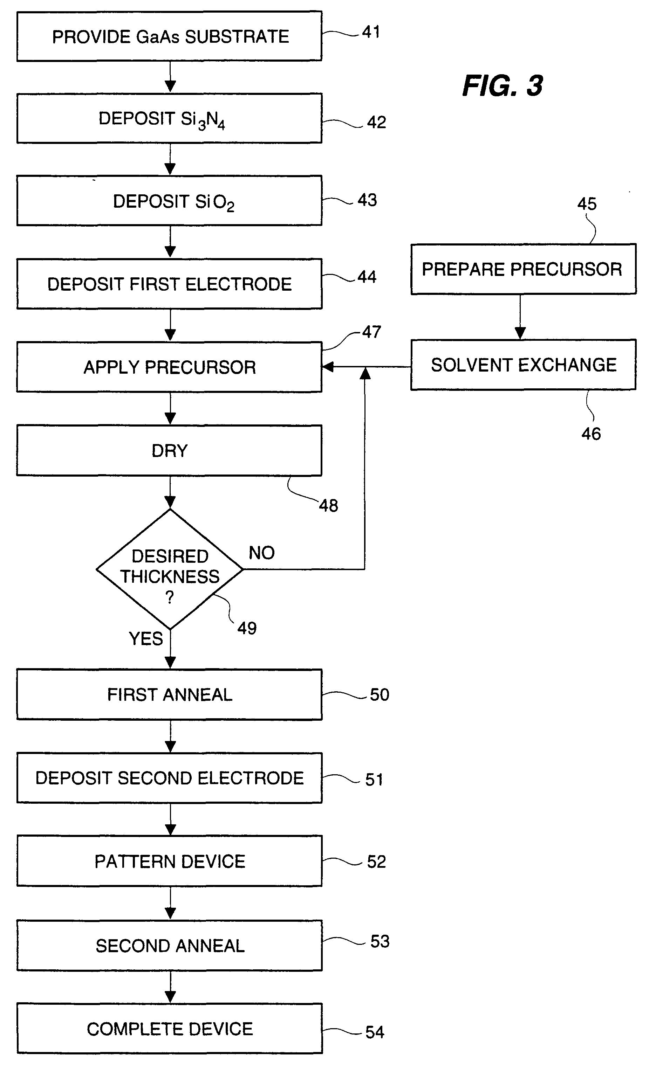

Turning now to Fig. 3, a flow chart of the process for fabricating capacitors 10 according to the invention is shown. The process shall be discussed in terms of the embodiment of Fig. 1, but could just as well be discussed in terms of the other embodiments also. In step 41 a GaAs substrate 11 is provided. This substrate 11 is made according to conventional methods of growing GaAs crystals. In step 42 a layer of silicon nitride of about 1500Å thick is deposited, preferably by plasma enhanced chemical vapor deposition (PECVD), although other methods may also be used. Then a layer 14 of silicon dioxide about 1000 Å thick is deposited in step 43, by any conventional method, such as PECVD or wet growth. In step 44 a first electrode 16 is deposited. Preferably first electrode 16 comprises an adhesion layer 18, preferably of titanium and about 200 Å thick, and a layer 20 of platinum about 2000 Å thick, both deposited preferably by sputtering. A metal oxide precursor is prepared in step 45; this may be just prior to the application step 47, but usually a stock solution is prepared and stored well prior to the application. The metal oxide is barium strontium titanate, and the precursor is preferably prepared as described in United States patent application Serial No. 08/132,744. The foregoing patent application discloses a method of making a metal oxide which utilizes the combination of a metal alkoxycarboxylate, such as a barium alkoxycarboxylate, and a metal alkoxide, such as titanium isopropoxide. Specifically, a BST precursor is made by reacting barium with 2-methoxyethanol and 2-ethylhexanoic acid, adding strontium, allowing the mixture to cool, adding titanium isopropoxide and 2-methoxyethanol, and heating to obtain a final BST concentration of about 0.5 moles. As disclosed in United States Patent application Serial No. 08/132,744 and co-owned United States patent application Serial No. 08/165,082, which were incorporated by reference in the corresponding United States patent application to the present application, during the heating, the maximum temperature is 116 °C which ensures that all isopropanol and water will be boiled out. Thus, the precursor is essentially anhydrous. If a dopant is to be added, a dopant precursor solution is prepared and added to the precursor in step 45. Just prior to the application step, a solvent exchange step 46 is preferably performed. That is, a stock solution prepared as above is removed from storage, and the solvent that is convenient for manufacturing and/or which makes a precursor that stores well, such as xylene, is exchanged for a solvent that has a good viscosity for the application process, such n-butyl acetate for a spinning application process. The exchange is performed by adding the new solvent and distilling out the old. Preferably, for a spin-on process the concentration of the spin-on precursor solution is 0.29 - 0.31 moles, which is controlled at the solvent exchange step 46. In step 47 the precursor is applied to the substrate 23, preferably by spinning at 1500 RPM to 2000 RPM for 20 seconds to 60 seconds. However, other application methods may be used, for example, a misted deposition process as described in United States patent application Serial No. 07/993,380, which is hereby incorporated by reference. In steps 48 and 50, the precursor is treated to form the metal oxide dielectric material 22 on substrate 23. The treating is by drying and annealing. The drying is preferably in air or dry nitrogen, and is at a relatively high temperature as compared to the prior art, i.e. at from 200 °C to 500 °C. Typically it is performed at 400 °C for 2 minutes in air. This high temperature drying step has been found to be essential to obtain predictable properties in BST. After drying, if the film 22 is not of the desired thickness, the application and drying steps 47 and 48 are repeated until the desired thickness is reached. Usually two to three repetitions of steps 47 and 48 are required to reach the thickness of about 2000 Å When the desired thickness is obtained, the dried precursor is annealed in step 50 to form dielectric 22. The annealing is referred to as the first anneal to distinguish it from a later anneal. The anneal is preferably performed in oxygen at a temperature of from 600°C to 850 °C for from 1 minute to 90 minutes. Typically, it is performed at 700°C for 60 minutes in O₂ in a push/pull process including 10 minutes for the "push" into the furnace and 10 minutes for the "pull" out of the furnace. Careful control of this anneal temperature and time is also essential for predicable results. The resulting layer 22 is preferably about 2000 Å thick. In step 51 a second electrode 24 is deposited, preferably by sputtering, and preferably formed of about 2000 Åthick platinum. The device is then patterned in step 52, which may comprise only the patterning of the second electrode if any patterning was done after deposition of the first electrode. It is important that the device be patterned before the second anneal step 53 so that patterning stresses are removed by the anneal and any oxide defects created by the patterning are corrected. The second anneal 53 is preferably performed at the same temperature as the first anneal though variance within a small temperature range of 50 °C to 100 °C about the first anneal temperature is possible. The time for the second anneal is preferably less than for the first anneal, generally being about 30 minutes, though again a range of times from about 1 minute to 90 minutes is possible depending on the sample. Again, careful control of the anneal parameters is important to obtain predictable results. In some instances it is desirable to skip the second anneal altogether. Finally, in step 54 the device is completed and evaluated.

Three samples of a BST capacitor 10 were made from a stock precursor solution having a stoichiometric content of barium, strontium and titanium as specified in the formula Ba_{0.7}Sr_{0.3}TiO. The process was as described above, except that for the first sample the first and second anneal steps were performed at 800 °C, in the second sample the first and second anneal steps were performed at 700 °C, and in the third sample the first and second anneal steps were performed at 650 °C. The electrical properties of the samples were evaluated with results as shown in FIG. 3, a graph of capacitance in farads versus frequency in gigahertz. To provide a basis of comparison, the dotted horizontal line shows the capacitance for an ideal material with dielectric constant, e, of 300. The capacitance of the sample annealed at 800 °C drops off sharply as the frequency approaches 1 gigahertz. The capacitance of the sample annealed at 700 °C does not drop off until beyond 1 gigahertz, and the capacitance of the sample annealed at 650 °C continues flat out to nearly 10 gigahertz. However, the value of the capacitance drops by a factor of about 5 between the sample annealed at 800 °C and the sample annealed at 700 °C, and by another factor of a little over 10 between the sample annealed at 700 °C and the sample annealed at 650 °C. As indicated by the dotted line, for the sample annealed at 700 °C, the capacitance is still significantly higher than the capacitance, say for silicon dioxide, which has a dielectric constant of about 3.9, thus using the process of the invention, it is possible to fabricate a material that has a high capacitance well beyond 1 gigahertz.

## Claims

1. A method of fabricating a high capacitance thin film capacitor device on a gallium arsenide substrate (11), said method comprising the steps of:
forming a barrier layer (12) on said gallium arsenide substrate; forming a stress reduction layer (14) on said barrier layer; forming a first electrode (16) on said stress reduction layer; forming a dielectric material (22) on a said first electrode; and forming a second electrode (24) on said dielectric material, wherein said step of forming a dielectric material on said first electrode comprises:
providing a liquid precursor solution including barium, strontium, and titanium metals,
applying said liquid precursor to said first electrode (16) ;
drying said liquid precursor on said first electrode at a temperature ranging from 200°C to 500°C to yield a dried precursor; and
annealing said dried precursor on said first electrode at a temperature ranging from 600°C to 850°C to form barium strontium titanate as said dielectric material (22).

2. A method as in claim 1, wherein said step of providing a liquid precursor includes providing a solution comprising said barium, strontium, and titanium metal moieties in a first solvent, and then performing a solvent exchange step to provide said liquid precursor comprising a second solvent.

3. A method as in claim 1, wherein said liquid precursor comprises a metal alkoxycarboxylate.

4. A method as in claim 1, wherein said stress reduction layer (14) formed on said barrier layer (12) comprises silicon dioxide.

5. A method as in claim 4, wherein said silicon dioxide stress reduction layer (14) is formed with a thickness of about 1000Å, and said barrier layer (12) is formed of Si₃N₄ and with a thickness of about 1500Å.

6. A method as in claim 1, wherein said step of annealing comprises heating said dried precursor on said first electrode (16) to a temperature of about 650°C in order to establish a stable capacitance in said capacitor device with essentially no rolloff at frequencies out to at least 3 GHz.

7. A method as in claim 1, wherein said annealing step is conducted for a time between 1 minute and 90 minutes, and a second anneal of said barium strontium titanate is subsequently carried out for a time between 1 minute and 90 minutes.

8. A method as in claim 1, wherein said barium strontium titanate (22) has the formula Ba_{0.7}Sr_{0.3}TiO₃.

9. A method as in claim 1, wherein said step of forming said first electrode (16) comprises forming an adhesion layer (18) selected from the group titanium, tantalum, nickel, tantalum silicide, nickel silicide, and palladium; and forming a second layer (20) on said adhesion layer.

10. A high capacitance thin film capacitor device formed by the method of any one of claims 1-9 comprising: a gallium arsenide substrate (11); a barrier layer (12) formed on said substrate; a stress reduction layer (14) on said barrier layer; and a capacitor (10) on said stress reduction layer, said capacitor comprising a first electrode (16), a second electrode (24), and a dielectric material (22) between said electrodes, said dielectric material being a barium strontium titanate layer having a stable capacitance with essentially no rolloff at frequencies out to at least one GHz.

11. A high capacitance thin film capacitor device as set forth in claim 10, wherein said stable capacitance has essentially no rolloff at frequencies out to at least three GHz.

12. A high capacitance thin film capacitor device as set forth in claim 10, wherein said stable capacitance has essentially no rolloff at frequencies out to nearly ten GHz.

## Patentansprüche

1. Verfahren zur Herstellung einer Dünnfilm-Kondensator-Vorrichtung mit hoher Kapazität auf einem Galliumarsenid-Substrat (11), wobei das Verfahren die Schritte umfaßt, daß man
- eine Barriere-Schicht (12) auf dem Galliumarsenid-Substrat bildet; eine Spannungs-Reduktionsschicht (14) auf der Barriere-Schicht bildet; eine erste Elektrode (16) auf der Spannungs-Reduktionsschicht bildet; ein dielektrisches Material (22) auf der ersten Elektrode bildet und eine zweite Elektrode (24) auf dem dielektrischen Material bildet, worin der Schritt der Ausbildung eines dielektrischen Materials auf der ersten Elektrode umfaßt, daß man
- eine flüssige Vorstufen-Lösung bereitstellt, die Barium, Strontium und Titan in Form der Metalle einschließt;
- die flüssige Vorstufe auf die erste Elektrode (16) aufbringt;
- die flüssige Vorstufe auf der ersten Elektrode bei einer Temperatur im Bereich von 200 °C bis 500 °C unter Erhalt einer trockenen Vorstufe trocknet; und
- die getrocknete Vorstufe auf der ersten Elektrode bei einer Temperatur im Bereich von 600 °C bis 850 °C unter Bildung von Bariumstrontiumtitanat als dielektrisches Material (22) glüht.

2. Verfahren nach Anspruch 1, worin der Schritt des Schaffens einer flüssigen Vorstufe einschließt, daß man eine die Metall-Einheiten Barium, Strontium und Titan umfassende Lösung in einem ersten Lösungsmittel bereitstellt und anschließend einen Lösungsmittel-Austausch-Schritt durchführt und so die flüssige Vorstufe bereitstellt, die ein zweites Lösungsmittel umfaßt.

3. Verfahren nach Anspruch 1, worin die flüssige Vorstufe ein Metallalkoxycarboxylat umfaßt.

4. Verfahren nach Anspruch 1, worin die Spannungs-Reduktionsschicht (14), die auf der Barriere-Schicht (12) gebildet ist, Siliciumdioxid umfaßt.

5. Verfahren nach Anspruch 4, worin die Spannungs-Reduktionsschicht (14) aus Siliciumdioxid mit einer Dicke von etwa 1000 Å ausgebildet ist und die Barriere-Schicht (12) aus Si₃N₄ und mit einer Dicke von etwa 1500 Å gebildet ist.

6. Verfahren nach Anspruch 1, worin der Schritt des Glühens das Erhitzen der trockenen Vorstufe auf der ersten Elektrode (16) auf eine Temperatur von etwa 650 °C umfaßt, um eine stabile Kapazität in der Kondensator-Vorrichtung bei im wesentlichen keinem Abfall bei Frequenzen bis hinaus zu wenigstens 3 GHz zu etablieren.

7. Verfahren nach Anspruch 1, worin der Schritt des Glühens für eine Zeit zwischen 1 min und 90 min durchgerührt wird und ein zweiter Schritt des Glühens des Bariumstrontiumtitanats anschließend für eine Zeit zwischen 1 min und 90 min durchgeführt wird.

8. Verfahren nach Anspruch 1, worin das Bariumstrontiumtitanat (22) die Formel Ba_{0,7}Sr_{0,3}TiO₃ hat.

9. Verfahren nach Anspruch 1, worin der Schritt der Bildung der ersten Elektrode (16) umfaßt, daß man eine Adhäsionsschicht (18) bildet, die gewählt ist aus der Gruppe Titan, Tantal, Nickel, Tantalsilicid, Nickelsilicid und Palladium, und daß man eine zweite Schicht (20) auf der Adhäsionsschicht bildet.

10. Dünnfilm-Kondensatorvorrichtung mit hoher Kapazität, gebildet durch das Verfahren nach einem der Ansprüche 1 bis 9, umfassend: ein Galliumarsenid-Substrat (11), eine Barriere-Schicht (12), die auf dem Substrat gebildet ist; eine Spannungs-Reduktionsschicht (14) auf der Barriere-Schicht und einen Kondensator (10) auf der Spannungsreduktionsschicht, wobei der Kondensator eine erste Elektrode (16), eine zweite Elektrode (24) und ein dielektrisches Material (22) zwischen den Elektroden umfaßt, wobei das dielektrische Material eine Bariumstrontiumtitanat-Schicht mit einer stabilen Kapazität mit im wesentlichen keinem Abfall bei Frequenzen bis hinaus zu wenigstens 1 GHz ist.

11. Dünnfilm-Kondensator-Vorrichtung mit hoher Kapazität nach Anspruch 10, worin die stabile Kapazität im wesentlichen keinen Abfall bei Frequenzen bis hinaus zu wenigstens 3 GHz hat.

12. Dünnfilm-Kondensator-Vorrichtung mit hoher Kapazität nach Anspruch 10, worin die stabile Kapazität im wesentlichen keinen Abfall bei Frequenzen bis hinaus zu etwa 10 GHz hat.

## Revendications

1. Procédé de fabrication d'un dispositif de condensateur à pellicule mine de capacité élevée sur un substrat d'arséniure de gallium (11), ledit procédé comprenant les étapes suivantes :
la formation d'une couche barrière (12) sur ledit substrat d'arséniure de gallium ; la formation d'une couche de réduction de tension (14) sur ladite couche barrière ; la formation d'une première électrode (16) sur ladite couche de réduction de tension ; la formation d'un matériau diélectrique (22) sur une dite première électrode ; et la formation d'une seconde électrode (24) sur ledit matériau diélectrique, **caractérisé en ce que** ladite étape de formation d'un matériau diélectrique sur ladite première électrode comprend :
la foumiture d'une solution de précurseur liquide comprenant les métaux baryum, strontium, et titane ;
l'application dudit précurseur liquide sur ladite première électrode (16) ;
le séchage dudit précurseur liquide sur ladite première électrode à une température dans la plage de 200°C à 500°C pour donner un précurseur sec ; et
le recuit dudit précurseur séché sur ladite première électrode à une température dans la plage de 600°C à 850°C pour former du titanate de baryum strontium comme dit matériau diélectrique (22).

2. Procédé selon la revendication 1, **caractérisé en ce que** ladite étape de fourniture d'un précurseur liquide comprend la fourniture d'une solution comprenant lesdits groupements métalliques de baryum, strontium, et titane dans un premier solvant, et ensuite la réalisation d'une étape d'échange de solvant pour fournir ledit précurseur liquide comprenant un second solvant.

3. Procédé selon la revendication 1, **caractérisé en ce que** ledit précurseur liquide comprend un alcoxycarboxylate métallique.

4. Procédé selon la revendication 1, **caractérisé en ce que** ladite couche de réduction de tension (14) formée sur ladite couche barrière (12) comprend du dioxyde de silicium.

5. Procédé selon la revendication 4, **caractérisé en ce que** ladite couche de réduction de tension (14) est formée avec une épaisseur d'environ 1000 Å et ladite couche barrière (12) est formée de Si₃N₄ et avec une épaisseur d'environ 1500 Å.

6. Procédé selon la revendication 1, **caractérisé en ce que** ladite étape de recuit comprend le chauffage dudit précurseur séché sur ladite première électrode (16) à une température d'environ 650°C de manière à établir une capacité stable dans ledit dispositif de condensateur avec sensiblement pas de sortie à des fréquences hors d'au moins 3 GHz.

7. Procédé selon la revendication 1, **caractérisé en ce que** ladite étape de recuit est effectuée pendant une durée entre 1 minute et 90 minutes, et un second recuit dudit titanate de baryum strontium est effectué postérieurement pendant une durée entre 1 minute et 90 minutes.

8. Procédé selon la revendication 1, **caractérisé en ce que** ledit titanate de baryum strontium (22) a la formule Ba_{0,7}Sr_{0,3}TiO₃.

9. Procédé selon la revendication 1, **caractérisé en ce que** ladite étape de formation de ladite première électrode (16) comprend la formation d'une couche d'adhésion (18) choisie dans le groupe constitué par le titane, le tantale, le nickel, le siliciure de tantale, le siliciure de nickel, et le palladium ; et la formation d'une seconde couche (20) sur ladite couche d'adhésion.

10. Dispositif de condensateur à pellicule mince à capacité élevée formé par le procédé selon l'une quelconque des revendications 1 à 9, comprenant un substrat d'arséniure de gallium (11) ; une couche barrière (12) formée sur ledit substrat ; une couche de réduction de tension (14) sur ladite couche barrière ; et un condensateur (10) sur ladite couche de réduction de tension, ledit condensateur comprenant une première électrode (16), une seconde électrode (24), et un matériau diélectrique (22) entre lesdites électrodes, ledit matériau diélectrique étant du titanate de baryum strontium ayant une capacité stable avec essentiellement pas de tombée à des fréquences d'au moins un GHz.

11. Dispositif de condensateur à pellicule mince à capacité élevée tel que mentionné dans la revendication 10, **caractérisé en ce que** ladite capacité stable n'a essentiellement pas de tombée à des fréquences d'au moins trois GHz.

12. Dispositif de condensateur à pellicule mince à capacité élevée tel que mentionné dans la revendication 10, **caractérisé en ce que** ladite capacité stable n'a essentiellement pas de tombée à des fréquences au voisinage de dix GHz.
